# EUROPEAN PATENT APPLICATION

(11) **EP 4 432 332 A1**
(43) Date of publication of application: **18.09.2024**
(21) Application number: 24163222.3
(22) Date of filing: 13.03.2024
(51) Int. Cl.: H01L 21/36

(54) **LAMINATED STRUCTURE AND SEMICONDUCTOR ELEMENT**

(30) Priority: 13.03.2023 JP 2023038929
(71) Applicant: Flosfia Inc., Kyoto 615-8245 (JP)
(72) Inventor: Ando, Hiroyuki, Kyoto, 615-8245 (JP); Tsukamoto, Naoyuki, Kyoto, 615-8245 (JP); Kato, Yuji, Kyoto, 615-8245 (JP)
(74) Representative: Gulde & Partner

(57) **Abstract**

The present disclosure provides a laminated structure suitable for semiconductor elements.

The laminated structure includes a first oxide layer having a trench structure on its surface and a second oxide layer laminated along the trench structure. A difference in thickness between centers of a bottom and a sidewall of the second oxide layer is less than 30%.

## Description

### [Technical Field]

The present disclosure relates to a laminated structure useful as a power device or the like, a semiconductor element including the laminated structure, and a semiconductor system.

### [Background Art]

Patent Literature 1 describes that an oxide semiconductor film is formed from a raw material solution containing iridium acetylacetonato and gallium acetylacetonato. Patent Literature 2 describes that a p type oxide semiconductor film is formed from a raw material solution containing iridium acetylacetonato, gallium acetylacetonato, and an organometallic salt of magnesium as a dopant raw material.

In the section " Background Art", aspects of the present disclosure are described in a technical or operational context to assist for those skilled in the art to understand the scope and the usefulness of the present disclosure. Unless expressly specified otherwise, the descriptions herein are not necessarily acknowledged to be prior arts merely for reason that prior arts are included in the section " Background Art".

### [Related Art]

### [Patent Literature]

Patent Literature 1: WO 2022/030647
Patent Literature 2: WO 2022/030648

### [Summary of Invention]

Hereinafter, a simplified summary of the present disclosure will be presented to allow those skilled in the art to basically understand the present disclosure. This summary is not intended to identify important elements in aspects of the present disclosure or to restrict the scope of the present disclosure. An object of the summary of the present disclosure is to present, in a simplified form, some concepts disclosed herein as a preface to more detailed descriptions presented later.

### [Technical Problem]

An object of the present disclosure is to provide a laminated structure suitable for semiconductor elements.

### [Solution to Problem]

To solve the above problems, the laminated structure according to an aspect of the present disclosure includes a first oxide layer having a trench on its surface and a second oxide layer laminated along the trench and having at least a bottom, a sidewall, and a curved portion, in which a difference in a film thickness between the bottom and the sidewall of the second oxide layer is less than 30%.

To solve the above problems, the laminated structure according to an aspect of the present disclosure includes a first oxide layer having a trench on its surface and a second oxide layer laminated along the trench and having at least a bottom, a sidewall, and a curved portion, in which the second oxide layer contains, as a major component, a mixed oxide crystal including an oxide of a first metal selected from Group 13 metals in the periodic table and an oxide of a second metal different from the first metal, and a difference in a second metal content between the bottom and the sidewall of the second oxide layer is less than 30%.

That is, the present disclosure relates to the following disclosure.
[1] A laminated structure comprising a first oxide layer having a trench structure on its surface and a second oxide layer laminated along the trench structure, wherein a difference in thickness between centers of a bottom and a sidewall of the second oxide layer is less than 30%.
[2] A laminated structure comprising a first oxide layer having a trench structure on its surface and a second oxide layer laminated along the trench structure, wherein the second oxide layer contains an oxide of a first metal selected from Group 13 metals in the periodic table and an oxide of a second metal selected from Group 6 metals and Group 9 metals in the periodic table, and a difference in a second metal content between regions around centers of a bottom and a sidewall of the second oxide layer is less than 30%.
[3] The laminated structure according to [1] or [2], wherein the trench structure comprises a plurality of trench grooves.
[4] The laminated structure according to [2] or [3], wherein a major component of the second oxide layer is a mixed crystal of the oxide of the first metal and the oxide of the second metal.
[5] The laminated structure according to any one of [2] to [4], wherein the first metal is gallium.
[6] The laminated structure according to any one of [2] to [5], wherein the second metal is a Group 9 metal in the periodic table.
[7] The laminated structure according to [6], wherein the second metal is iridium.
[8] The laminated structure according to any one of [1] to [7], wherein the second oxide layer has a minimum film thickness of 30 nm or larger.
[9] The laminated structure according to any one of [1] to [8], wherein the trench structure has a groove depth of within a range of 0.1 µm to 10 µm.
[10] The laminated structure according to any one of [1] to [9], wherein the trench structure has a groove width of within a range of 0.1 µm to 5.0 µm.
[11] The laminated structure according to any one of [1] or [10], wherein the first oxide layer is crystalline.
[12] The laminated structure according to [11], wherein the first oxide layer has a corundum structure.
[13] The laminated structure according to [12], wherein the trench structure has a bottom of m-plane and a sidewall of c-plane.
[14] A semiconductor element comprising the laminated structure according to any one of [1] to [13], and an electrode.
[15] A power conversion device comprising the semiconductor element according to [14].
[16] A control system comprising the semiconductor element according to [14].

### [Advantageous Effect of the Disclosure]

The laminated structure according to the present disclosure is suitable for semiconductor elements.

### [Brief Description of Drawings]

FIG. 1 is a schematic top view of a laminated structure according to the first embodiment.
FIG. 2 is a schematic cross-sectional view of the laminated structure according to the first embodiment.
FIG. 3 is a schematic cross-sectional view of a trench of the laminated structure according to the first embodiment.

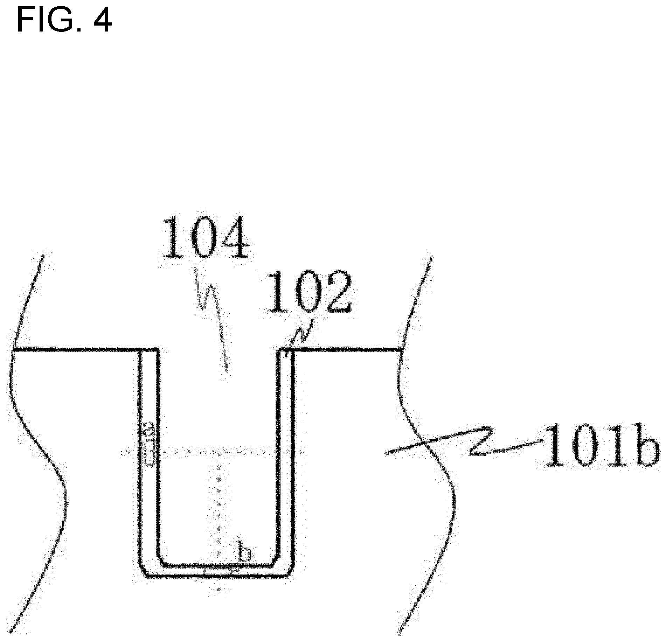

FIG. 4 is a schematic cross-sectional view of a trench of the laminated structure according to the first embodiment.
FIG. 5 is a schematic cross-sectional view illustrating a method of manufacturing the laminated structure according to the first embodiment.
FIG. 6 is a schematic top view of a semiconductor element including the laminated structure according to the first embodiment.
FIG. 7 is a schematic cross-sectional view of the semiconductor element including the laminated structure according to the first embodiment.
FIG. 8 is a block diagram illustrating an example of a control system having a semiconductor element according to an aspect of the present disclosure.
FIG. 9 is a circuit diagram illustrating an example of the control system having the semiconductor element according to the aspect of the present disclosure.
FIG. 10 is a block diagram illustrating an example of the control system having the semiconductor element according to the aspect of the present disclosure.
FIG. 11 is a circuit diagram illustrating an example of the control system having the semiconductor element according to the aspect of the present disclosure.
FIG. 12 is a schematic cross-sectional view of a trench in a laminated structure according to a variant example of the present disclosure.
FIG. 13 is a schematic cross-sectional view of the semiconductor element according to the aspect of the present disclosure.
FIG. 14 is a diagram presenting TEM images in an example and a comparative example.
FIG. 15 is a diagram presenting measurement results of I-V characteristics in the example and the comparative example.
FIG. 16 is a schematic diagram of a film formation device 650 according to the aspect of the present disclosure.
FIG. 17 is a schematic diagram of a film formation device 651 according to the aspect of the present disclosure.

### [Description of Embodiments]

Aspects of the present disclosure and their various features and predominant details will be explained and/or described with reference to the figures, and more specifically explained with reference to non-limiting aspects and examples as described herein below. As will be obvious to those skilled in the art, even if not described herein, the features illustrated in the figures are not necessarily depicted at a fixed scale. Note that one feature in one aspect may be used alone or in combination with other features also in other aspects. Descriptions on well-known elements and processing techniques may be omitted so as not to undesirably obscure the aspects of the present disclosure. The examples used herein are merely intended to assist understanding of the present disclosure and to allow those skilled in the art to implement the aspects of the present disclosure. Thus, the aspects and examples herein should not be construed only by the scope of the present disclosure, and are defined only by claims and applicable law. Furthermore, in the figures of the present disclosure, same reference signs represent same sections.

The terms "first", "second", and the like are used to specify various elements used herein, but the elements are not limited to these terms. The terms "first", "second", and the like are used only to distinguish one element from other elements. For example, without departing from the scope of the present disclosure, the first element may be referred to as the second element, and the second element may be referred to as the first element. As used herein, the term "and/or" encompasses one of or some of or all combinations of listed items.

It should be understood that, when using an expression that an element such as a layer, a region, and a substrate is located "on" or extends "onto the top of" another element, the element may be located directly on or extends directly onto the top of another element, or any element may be interposed therebetween. On the other hand, when using an expression that an element is located "directly on" or extends "directly onto the top of" another element, no element is interposed therebetween. Similarly, it should be understood that, when using an expression that an element such as a layer, a region, and a substrate "spans" or extends "over" another element, the element may directly span or extend directly over another element, and any element may be interposed therebetween. On the other hand, when using an expression that an element "directly spans" or extends "directly over" another element, no element is interposed therebetween. It should be understood that, when using an expression that an element is "connected" or "coupled" to another element, the element may be directly connected or coupled to another element, or any element may be interposed therebetween. On the other hand, when using an expression that an element is "directly connected" or "directly coupled" to another element, no element is interposed therebetween. Furthermore, it should be understood that, when using an expression that an element is "laminated" on another element, the element may be directly laminated on another element, or any element may be interposed therebetween. On the other hand, when using an expression that an element is "directly laminated" on another element, no element is interposed therebetween.

The terms used herein are intended to describe only specific aspects and are not intended to limit the present disclosure. The terms "include" and "contain" used herein represent the presence of the described elements and do not exclude the presence of one or a plurality of other elements.

Unless otherwise defined, all terms used herein (including technical and scientific terms) have the same meaning as of generally terms understood by those skilled in the art of the present disclosure. The terms used herein are interpreted to have meanings not inconsistent with the context herein and the meaning in the related arts. Unless defined herein, it should be understood that terms used herein should not be interpreted in an idealized or excessively formalistic sense.

In the present disclosure, unless otherwise defined, the first oxide layer side viewed from the second oxide layer is defined as a lower side to define a "top" and a "bottom". In the present specification, the "top view" may be rephrased as "plane view".

### (First Embodiment)

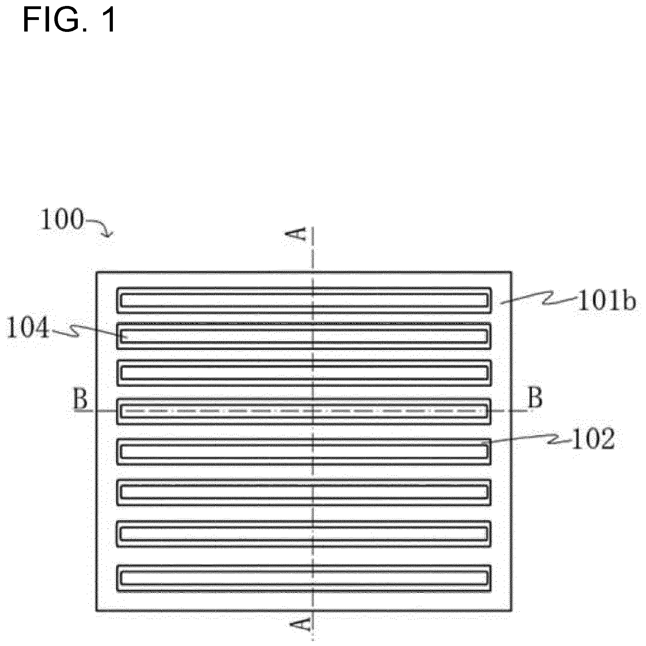

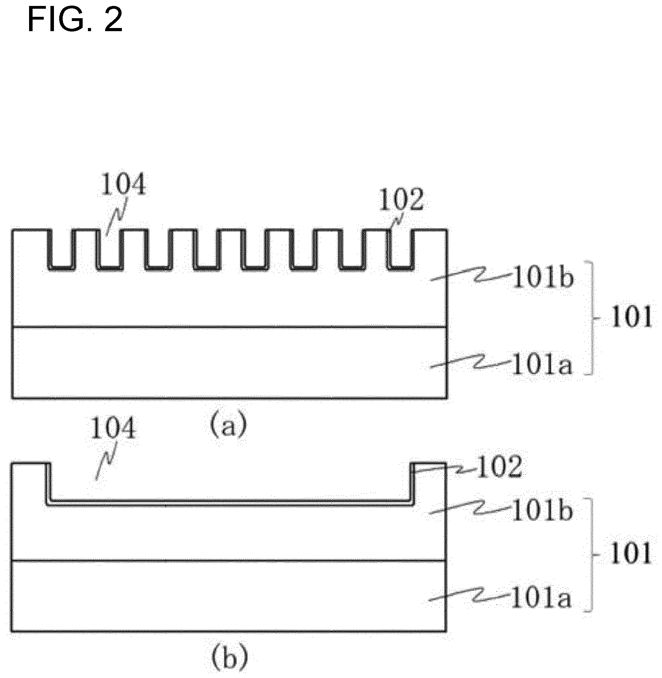

FIG. 1 is a schematic top view of a laminated structure 100 according to the first embodiment. FIG. 2(a) and FIG. 2(b) are schematic cross-sectional views of the A and B cross sections respectively in FIG. 1. The laminated structure 100 in FIG. 1 and FIG. 2 includes a first oxide layer 101 and a second oxide layer 102. The first oxide layer 101 has a trench 104 including a plurality of trench grooves on its surface, and the second oxide layer 102 is laminated on the trench 104 along the trench 104. As illustrated in FIG. 1, inside the trench 104, the plurality of trench grooves are formed in a strip pattern viewed from above. In the first embodiment, the first oxide layer 101 has an n+ type oxide semiconductor layer (oxide layer including an n type dopant) 101a and an n- type oxide semiconductor layer (oxide layer including an n type dopant and having an n type carrier density lower than of the n+ type oxide semiconductor layer 101a) 101b.

### (First Oxide Layer)

The first oxide layer 101 is not particularly limited as long as it contains a metal oxide as a major component. Examples of the metal include one or a plurality of metals selected from gallium (Ga), iridium (Ir), indium (In), rhodium (Rh), aluminum (Al), gold (Au), silver (Ag), platinum (Pt), copper (Cu), iron (Fe), manganese (Mn), nickel (Ni), palladium (Pd), cobalt (Co) ruthenium (Ru), chromium (Cr), molybdenum (Mo), tungsten (W), tantalum (Ta), zinc (Zn), lead (Pb), rhenium (Re), titanium (Ti), tin (Sn), magnesium (Mg), calcium (Ca), and zirconium (Zr). In the present disclosure, the metal contains preferably at least one or a plurality of metals of the third-period to sixth-period metals in the periodic table, more preferably at least one selected from gallium, indium, rhodium, iridium, and aluminum. In the present disclosure, the metal is preferably a Group 13 metal in the periodic table (aluminum, gallium, or indium), more preferably gallium.

A crystal structure of the first oxide layer 101 is not particularly limited. Examples of the crystal structure include a corundum structure, a β-gallia structure, and a hexagonal structure (e.g. ε structure). In the present disclosure, the first oxide layer 101 has preferably a corundum or β-gallia structure, more preferably a corundum structure. The "major component" refers to a component containing the metal oxide at a composition ratio of 50% or higher, preferably 70% or higher, more preferably 90% or higher in the oxide layer. For example, when the oxide semiconductor is an α-Ga₂O₃, the α-Ga₂O₃ only needs to be contained in the crystalline oxide semiconductor layer such that a gallium atomic ratio is 0.5 or higher in the metal elements of the crystalline oxide semiconductor layer. In the present disclosure, the atomic ratio of gallium in the metal elements of the crystalline oxide semiconductor layer is preferably 0.7 or higher, more preferably 0.8 or higher. The oxide semiconductor may be monocrystalline or polycrystalline. Also, the thickness of the first oxide layer 101 is not particularly limited as long as it does not hinder the object of the present disclosure. The thickness of the first oxide layer 101 is e.g. within a range of 5 µm to 40 µm.

In the first embodiment, the first oxide layer 101 has the n+ type oxide semiconductor layer 101a and the n- type oxide semiconductor layer 101b. The n+ type oxide semiconductor layer 101a has a carrier density higher than of the n- type oxide semiconductor layer 101b. The n+ type oxide semiconductor layer 101a has a carrier density of e.g. within a range of 1.0×10¹⁸/cm³ to 1.0×10²¹/cm³. The n+ type oxide semiconductor layer 101a and/or n- type oxide semiconductor layer 101b may contain an n type dopant. Examples of the n type dopant include tin, germanium, silicon, titanium, zirconium, vanadium, and niobium. The n- type oxide semiconductor layer 101b has a carrier density of e.g. within a range of 5.0×10¹⁵/cm³ to 5.0×10¹⁷/cm³. In the first embodiment, although the case in which the first oxide layer 101 has two n type oxide semiconductor layers has been described as an example, but the number of the n type oxide semiconductor layers is not limited thereto. The first oxide layer 101 may include three or more n type oxide semiconductor layers, or may include one n type oxide semiconductor layer.

### (Trench)

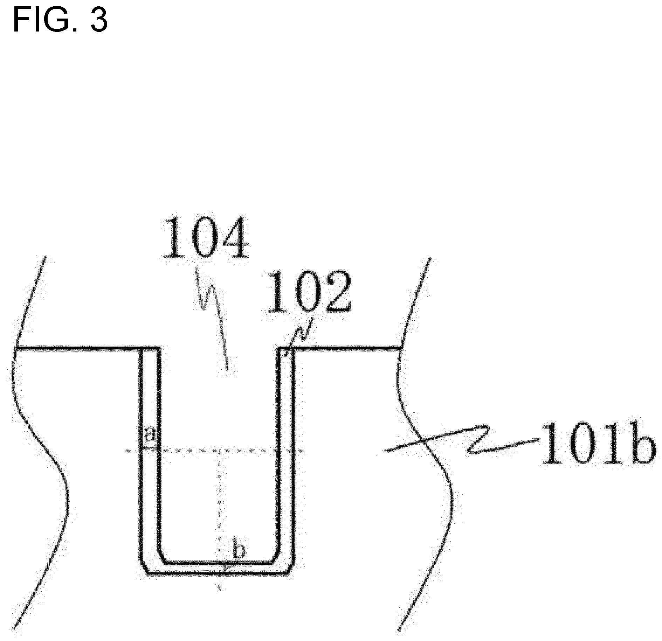

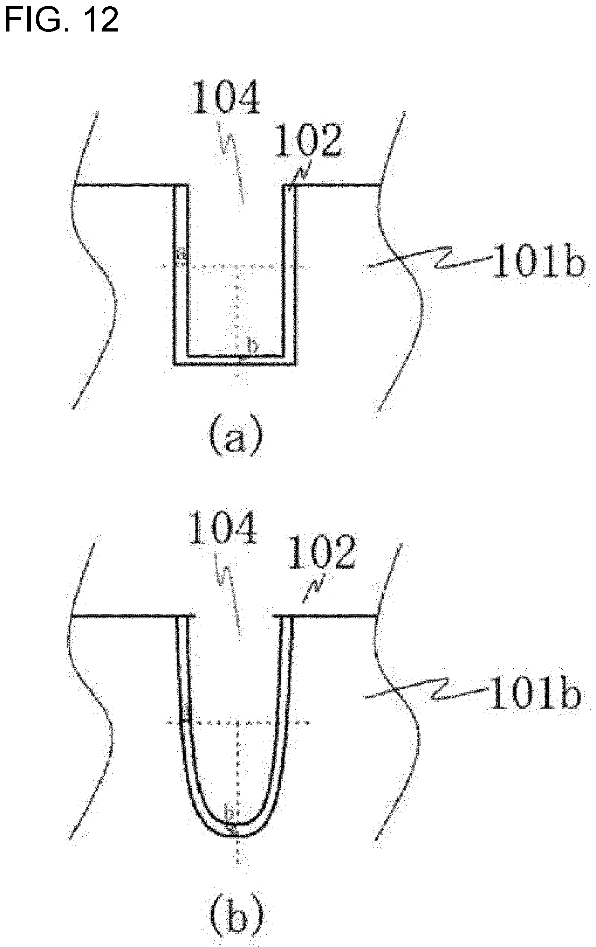

The first oxide layer 101 has a trench structure (trench 104) including a plurality of trench grooves on its surface. An enlarged view of a cross-sectional shape of the trench groove in the first embodiment is illustrated in FIG. 3. Examples of other cross-sectional shapes of the trench groove are illustrated in FIG. 12. In the present disclosure, the trench groove may have the cross-sectional shape illustrated in FIG. 3 or the cross-sectional shape illustrated in FIG. 12(a) or FIG. 12(b). In the present disclosure, the cross-sectional shape of the trench groove is not limited to these examples.

A depth and a width of the trench groove are not particularly limited as long as they do not hinder the object of the present disclosure. The trench groove has a depth of e.g. within a range of 0.1 µm to 10 µm, preferably 0.5 µm to 3.0 µm. The trench groove has a width of e.g. within a range of 0.1 µm to 5.0 µm, preferably 0.1 µm to 2.5 µm. In the present disclosure, the number of the trench grooves is not particularly limited, and there may be one trench groove or a plurality of trench grooves. When the trench structure includes a plurality of trench grooves, the number of the grooves is not particularly limited as long as the number is 2 or more. The number of the plurality of trench grooves may be 5 or more, 10 or more, or 20 or more.

### (Second Oxide Layer)

The second oxide layer 102 is laminated along the trench of the first oxide layer 101. The second oxide layer 102 includes the oxide of the first metal selected from Group 13 metals in the periodic table and the oxide of the second metal selected from Group 6 metals and Group 9 metals in the periodic table. Examples of the first metal include aluminum (Al), gallium (Ga), and indium (In). Examples of the second metal include d-block metals and/or Group 13 metals (aluminum, gallium, or indium) in the periodic table. In the present disclosure, the second metal is preferably a Group 9 metal in the periodic table. Examples of Group 6 metals in the periodic table include chromium (Cr), molybdenum (Mo), and tungsten (W). Examples of Group 9 metals in the periodic table include cobalt (Co), rhodium (Rh), and iridium (Ir). A content ratio of the second metal in all metal elements in the second oxide layer is not particularly limited, but is e.g. within a range of 0.05 to 0.30 in terms of atomic ratio.

In the present disclosure, it is preferable that a major component of the second oxide layer 102 is a mixed crystal of the first metal oxide and the second metal oxide. The term "major component" means the oxide that is contained at an atomic ratio of preferably 50% or higher, more preferably 70% or higher, even more preferably 90% or higher based on the total components of the second oxide layer, or may be contained at 100%. For example, when the oxide is an (Ir, Ga)₂O₃, the (Ir, Ga)₂O₃ only needs to be contained in the second oxide layer 102 such that a total gallium and iridium atomic ratio is 0.5 or higher in the total metal elements of the second oxide layer 102. In the present disclosure, the second oxide layer 102 has a band gap of preferably 4.5 eV or higher, more preferably 5.0 eV or higher. Also, in the present disclosure, it is preferable that the second oxide layer 102 is crystalline. In this case, the second oxide layer 102 may be e.g. monocrystalline or polycrystalline. The second oxide layer 102 has preferably a corundum structure or a β-gallia structure, more preferably a corundum structure. The second oxide layer 102 is e.g. a semiconductor layer having p type conductivity.

In the present disclosure, the second oxide layer 102 is preferably a crystal or mixed crystal of metal oxides containing gallium, more preferably gallium oxide or a mixed crystal thereof (e.g. α-Ga₂O₃ or a mixed crystal thereof). The second oxide layer 102 may contain a p type dopant. Examples of the p type dopant include, but are not limited to, elements such as Mg, Zn, Ca, H, Li, Na, K, Rb, Cs, Fr, Be, Sr, Ba, Ra, Mn, Fe, Co, Ni, Pd, Cu, Ag, Au, Cd, Hg, Tl, Pb, N, P, and combinations of two or more thereof. A concentration of the p type dopant may be e.g. about 1×10¹⁶/cm³ to 1×10²²/cm³.

The "periodic table" means the periodic table defined by International Union of Pure and Applied Chemistry (IUPAC). The "d-block" refers to elements having electrons satisfying the 3d, 4d, 5d, and 6d orbits. Examples of the d-block metal include scandium (Sc), titanium (Ti), vanadium (V), chromium (Cr), manganese (Mn), iron (Fe), cobalt (Co), nickel (Ni), copper (Cu), zinc (Zn), yttrium (Y), zirconium (Zr), niobium (Nb), molybdenum (Mo), technetium (Tc), ruthenium (Ru), rhodium (Rh), palladium (Pd), silver (Ag), cadmium (Cd), lutetium (Lu), hafnium (Hf), tantalum (Ta), tungsten (W), rhenium (Re), osmium (Os), iridium (Ir), platinum (Pt), gold (Au), mercury (Hg), lawrencium (Lr), rutherfordium (Rf), dubnium (Db), seaborgium (Sg), bohrium (Bh), hassium (Hs), meitnerium (Mt), darmstadtium (Ds), roentgenium (Rg), copernicium (Cn), and combinations of two or more thereof.

A difference in thickness between centers of the bottom and the sidewall in the second oxide layer 102 is less than 30%. The thickness in the center of the bottom and the thickness in the center of the sidewall are expressed by a thickness b and a thickness a respectively in FIG. 3. When the cross-sectional shape of the trench groove is as illustrated in FIG. 12(a) or FIG. 12(b), thicknesses in the centers of the sidewall and bottom are expressed by thicknesses a and b respectively in FIG. 12(a) and FIG. 12(b). The center of the bottom refers to e.g. a width-directional midpoint of the trench groove and is located at any point excluding length-directional edges of the trench groove. A film thickness in the center of the bottom refers to a dimension of a part where a line passing through the aforementioned point and parallel to the lamination direction (depth direction of the trench groove) and the second oxide layer 102 laminated inside the trench intersect each other.

The center of the sidewall refers to e.g. a depth-directional midpoint of the trench groove and is located at any point excluding length-directional edges of the trench groove. A film thickness in the center of the sidewall refers to a dimension of a part where a line passing through the aforementioned point and parallel to the lamination direction (width direction of the trench groove) and the second oxide layer 102 laminated inside the trench intersect each other.

The difference in the thickness between the center of the bottom and the center of the sidewall refers to a percentage calculated by dividing the film thickness difference between the larger thickness and the smaller thickness by the larger thickness. To calculate the thickness difference, the thicknesses in the center of the bottom and the center of the sidewall in one cross section are used. The thickness difference may be confirmed e.g. using a TEM (transmission electron microscopy) image of a cross section of the trench groove.

In the second oxide layer, a difference in the second metal content between a region around the center of the bottom and a region around the center of the sidewall in the trench groove is less than 30%. The difference in the second metal content between the regions around the centers of the bottom and the sidewall refers to a percentage calculated by dividing a difference between the higher content and the lower content of the second metal contents (%) in the total metal elements contained in the second oxide layer as measured using EDS (Energy dispersive x-ray spectroscopy) by the higher content.

### (Example of Manufacture Method)

A method of manufacturing the laminated structure configured as above will be explained below.

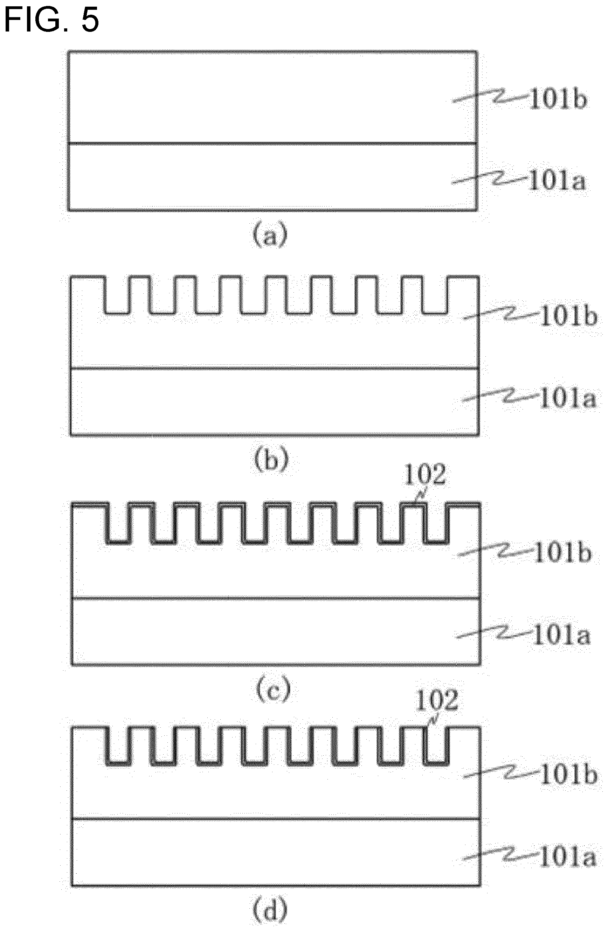

In the manufacturing process for the laminated structure according to the first embodiment, the n+ type oxide semiconductor layer 101a and the n- type oxide semiconductor layer 101b (collectively referred to as the first oxide layer) are laminated on a substrate (not illustrated) to obtain a laminate illustrated in FIG. 5(a). Subsequently, a plurality of trench grooves are formed on the surface of the n- type oxide semiconductor layer 101b using known photolithography and etching methods to obtain the laminate illustrated in FIG. 5(b). Before and after these processes, the substrate (not illustrated) may be removed or transferred to another conductive support substrate or the like. The second oxide layer is formed on the laminate illustrated in FIG. 5(b) using a known film formation method to obtain the laminate illustrated in FIG. 5(c). Then, if necessary, the second oxide layer is polished using a known polishing method (e.g. chemical mechanical polishing (CMP)) to obtain the laminated structure according to the first embodiment illustrated in FIG. 5(d).

It is possible to form the first and second oxide layers (hereinafter collectively also referred to as "oxide layers") e.g. by epitaxial crystal growth using a mist chemical vapor deposition (CVD) method or a mist epitaxy method.

### <Substrate>

The substrate is not particularly limited but is preferably, in the present disclosure, a crystalline substrate. The crystalline substrate is not particularly limited as long as it does not hinder the object of the present disclosure, and may be any known substrate, such as an insulating substrate, a conductive substrate, a semiconductor substrate, a monocrystalline substrate, and a polycrystalline substrate. Examples of the crystalline substrate include a substrate containing a crystalline material having a corundum structure as a major component. Note that the "major component" refers to a component containing the crystalline material at a composition ratio of 50% or higher, preferably 70% or higher, even more preferably 90% or higher in the substrate. Examples of the crystalline substrate having a corundum structure include a sapphire substrate and an α-gallium oxide substrate.

In the present disclosure, the crystal substrate is preferably a sapphire substrate. Examples of the sapphire substrate include a c-plane sapphire substrate, an m-plane sapphire substrate, an a-plane sapphire substrate, and an r-plane sapphire substrate. The sapphire substrate may have an off angle. The off angle is not particularly limited and is e.g. 0.01° or larger, preferably 0.2° or larger, more preferably 0.2° to 12°. A sapphire substrate having a-plane, m-plane, or r-plane as a crystal growth plane is preferable, and a c-plane or m-plane sapphire substrate having an off angle of 0.2° or larger is also preferable. The thickness of the crystalline substrate is not particularly limited, but is typically 10 µm to 20 mm, more preferably 10 µm to 1000 µm.

In the present disclosure, other layers such as a buffer layer and a stress relaxation layer may be provided on the crystalline substrate. Examples of the buffer layer include a layer including a metal oxide having the same crystal structure as that of the crystalline substrate or the crystalline oxide semiconductor. Examples of the stress relaxation layer include an epitaxial lateral overgrowth (ELO) mask layer.

The epitaxial crystal growth method is not particularly limited as long as it does not hinder the obj ect of the present disclosure and may be any known method. Examples of the epitaxial crystal growth method include a CVD method, a metal-organic chemical vapor deposition (MOCVD) method, a metal-organic vapor phase epitaxy (MOVPE) method, a mist CVD method, a mist epitaxy method, a molecular beam epitaxy (MBE) method, a hydride vapor phase epitaxy (HVPE) method, a pulse growth method, and an atomic layer deposition (ALD) method. In the present disclosure, it is preferable that the epitaxial crystal growth is performed using the mist CVD method or the mist epitaxy method.

In the mist CVD method or the mist epitaxy method, a raw material solution containing a metal is atomized (atomization step) to suspend droplets in air, the resulting atomized droplets are conveyed to the vicinity of the crystalline substrate by a carrier gas (conveyance step), and then the atomized droplets are thermally reacted (film formation step).

### (Raw Material Solution)

The raw material solution is not particularly limited as long as it contains a metal as a film formation material and is atomizable, and may contain inorganic or organic materials. The metal may be an elemental metal or a metal compound, and is not particularly limited as long as it does not hinder the object of the present disclosure. Examples of the metal include one or a plurality of metals selected from gallium (Ga), iridium (Ir), indium (In), rhodium (Rh), aluminum (Al), gold (Au), silver (Ag), platinum (Pt), copper (Cu), iron (Fe), manganese (Mn), nickel (Ni), palladium (Pd), cobalt (Co), ruthenium (Ru), chromium (Cr), molybdenum (Mo), tungsten (W), tantalum (Ta), zinc (Zn), lead (Pb), rhenium (Re), titanium (Ti), tin (Sn), magnesium (Mg), calcium (Ca), and zirconium (Zr). However, in the present disclosure, the metal includes preferably one or a plurality of metals selected from Group 6 metals, Group 9 metals, and Group 13 metals in the periodic table, more preferably at least one selected from gallium, indium, rhodium, iridium, and aluminum, most preferably at least gallium.

In the present disclosure, it is possible to desirably use a raw material solution of a metal in a form of a complex or a salt, dissolved or dispersed in an organic solvent or water. Examples of the complex form include an acetylacetonato complex, a carbonyl complex, an ammine complex, and a hydride complex. Examples of the salt form include an organometallic salt (e.g. metal acetate, metal oxalate, metal citrate), a metal sulfide, a metal nitride, a metal phosphate, and a metal halide (e.g. metal chloride, metal bromide, metal iodide).

In the present disclosure, it is preferable to use, as a raw material for the second metal, a raw material solution containing at least one of a metal complex having a ligand represented by the following formula (1) and a metal complex represented by the following formula (2). Use of such a preferable raw material makes it possible to form the second oxide layer having a more uniform film thickness and a more uniform composition ratio compared to e.g. a case using a conventional metal complex (acetylacetonato complex). More specifically, it is possible to form e.g. a film having a more uniform film thickness and a more uniform second metal content on the bottom and the sidewall. 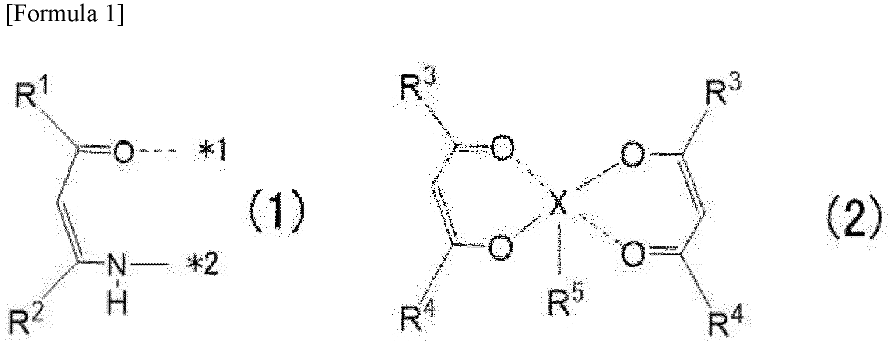 In the above formula (1), the dotted line represents a coordinate bond. *1 represents a coordinate bond position with a metal. *2 represents a bond position with a metal. Each of R¹ and R² independently represents an alkyl group having 1 to 6 carbon atoms.

In the above formula (2), each of R³ and R⁴ independently represents hydrogen atom, a halogen atom, an alkyl group having 1 to 6 carbon atoms, a phenyl group, or a tolyl group. R⁵ represents a halogen atom, an alkyl group having 1 to 6 carbon atoms, a formyl group, an acetoxy group, a sulfo group, a mesyl group, a nitro group, a nitroso group, or a phosphoryl group. X represents a Group 6 metal or Group 9 metal in the periodic table.

Examples of the ligand having the heterocyclic structure include pyridine, 2-methylpyridine, 2,4,6-trimethylpyridine, 4-dimethylaminopyridine, 2,6-lutidine, pyrimidine, pyridazine, pyrazine, oxazole, isoxazole, thiazole, isothiazole, imidazole, 1,2-dimethylimidazole, 3-(dimethylamino)propylimidazole, pyrazole, furazan, quinoline, isoquinoline, purine, 1H-indazole, quinazoline, cynoline, quinoxaline, phthalazine, pteridine, phenanthridine, 2,6-di-t-butylpyridine, 2,2'-bipyridine, 4,4'-dimethyl-2,2'-bipyridyl, 5,5'-dimethyl-2,2'-bipyridyl, 6,6'-di-t-butyl-2,2'-bipyridyl, 4,4'-diphenyl-2,2'-bipyridyl, 1,10-phenanthroline, 2,7-dimethyl-1,10-phenanthroline, 5,6-dimethyl-1,10-phenanthroline, and 4,7-diphenyl-1,10-phenanthroline.

The metal complex used in the present disclosure exhibits a high aqueous solution-solubility while having an excellent thermal stability. Furthermore, an aqueous solution containing such a metal complex does not precipitate during a long-term storage and is able to exhibit a high quality stability.

In particular, the metal complex having the ligand represented by the above formula (1) is allowed to be obtained by reacting a metal halide such as iridium trichloride with acetylacetonato in the presence of a water-soluble basic compound such as ammonia and tetramethylammonium hydroxide (TMAH).

The X in the metal complex is a Group 6 metal or a Group 9 metal in the periodic table, and specifically it is possible to use a metal selected from cobalt (Co), rhodium (Rh), iridium (Ir), chromium (Cr), molybdenum (Mo), and tungsten (W). Iridium (Ir) is particularly preferable due to its reactivity, aqueous solution-solubility, and the like.

Preferably, the aqueous solution containing the metal complex of the second metal according to the present disclosure is substantially free from organic solvents. This is because a flash point is lowered by organic solvents, and places and methods for using the organic solvents are restricted.

If the aqueous solution contains an organic solvent, an available organic solvent is preferably miscible with water as appropriate, such as methanol, ethanol, and isopropyl alcohol. An amount of the organic solvent is 10 mass % or less, more preferably 5 mass % or less based on the total amount of the solvents in the aqueous solution.

In particular, the metal is preferably iridium (Ir), and its metal complexes represented by the above formula (1) and the above formula (2) are specifically exemplified by metal complexes represented by the following formula (3) and following formula (4) respectively.

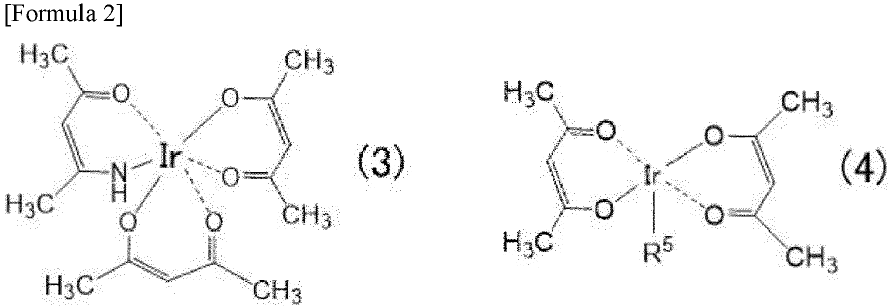

In the above formula (4), R⁵ represents a halogen atom, an alkyl group having 1 to 6 carbon atoms, a formyl group, an acetoxy group, a sulfo group, a mesyl group, a nitro group, a nitroso group, or a phosphoryl group. Above all, chlorine atom is particularly preferable from the viewpoint of a compound stability during compound synthesis.

The metal complex represented by the above formula (3) is synthesized by alkali treatment of iridium trichloride in the aqueous solution. It has been confirmed that metal complexes other than the metal complex represented by formula (3) include compounds represented by the following formulas (3-1) and (4-1). Thus, the metal complex aqueous solution used in the present disclosure also contains a metal complex represented by at least one of the following formulas (3-1) and (4-1).

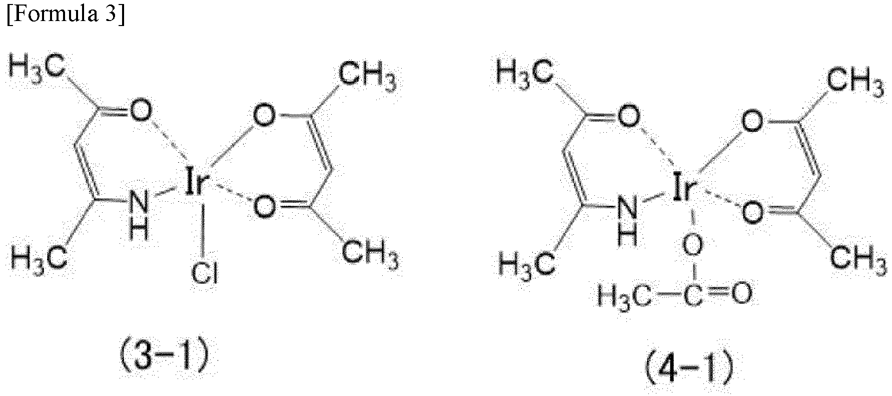

The metal complex according to the present disclosure may have counter cations in the aqueous solution. Examples of the counter cations include hydrogen ions and ammonium ions, and ammonium ions are particularly preferable. Ammonium ions become counter ions of the metal complex through neutralization using an alkaline aqueous solution such as ammonia water in the metal complex synthesis. When neutralization is performed using an aqueous solution of an acid such as hydrochloric acid, hydrogen ions become counter ions.

Examples of such a metal complex containing counter cations include metal complexes having counter cations, represented by the following formula (3-2) or (4-2). In this disclosure, the dotted line in each formula represents a coordination bond.

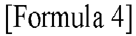

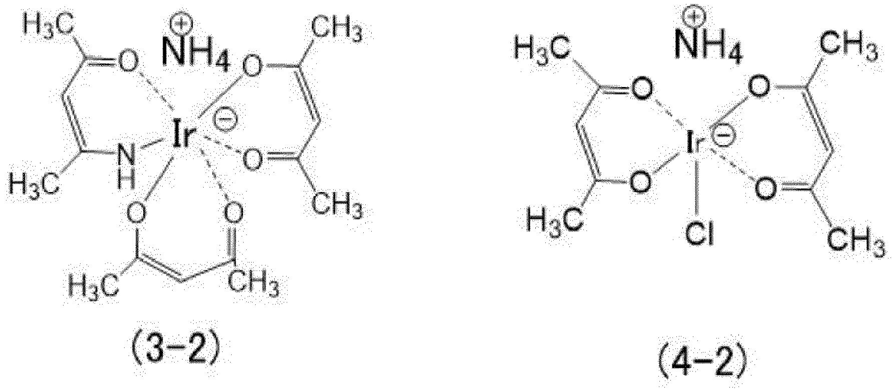

A solvent for the raw material solution is not particularly limited as long as it does not hinder the object of the present disclosure. The solvent may be an inorganic solvent such as water, an organic solvent such as alcohol, or a mixed solvent of inorganic and organic solvents. In the present disclosure, the solvent preferably contain water. Preferably, the solvent in the raw material solution of the second metal complex according to the present disclosure is substantially free from organic solvents.

It is also preferable that the raw material solution is mixed with additives such as a hydrohalogenic acid and an oxidant. Examples of the hydrohalogenic acid include a hydrobromic acid, a hydrochloric acid, and a hydriodic acid. Above all, a hydrobromic acid or a hydrochloric acid is preferable because they are capable of forming better quality films. Particularly, hydrochloric acid is preferable. Examples of the oxidant include a peroxide such as hydrogen peroxide (H₂O₂), sodium peroxide (Na₂O₂), barium peroxide (BaO₂), and benzoyl peroxide (C₆H₅CO)₂O₂, a hypochlorous acid (HClO), perchloric acid, nitric acid, ozone water, and an organic peroxide such as peracetic acid and nitrobenzene. When the additive is a hydrochloric acid, a hydrochloric acid content in the raw material solution is preferably 1 to 20% by mass, more preferably 3 to 10% by mass.

The raw material solution may contain a dopant. The dopant is not particularly limited as long as it does not hinder the object of the present disclosure. Examples of the dopant include n type dopants such as tin, germanium, silicon, titanium, zirconium, vanadium, and niobium, or p type dopants such as magnesium and calcium. Typically, a concentration of the dopant may be about 1×10¹⁶/cm³ to 1×10²²/cm³, or may be e.g. as low as about 1×10¹⁷/cm³ or lower. Furthermore, in the present disclosure, the concentration of the dopant may be as high as about 1×10²⁰/cm³ or higher.

### (Atomization Step)

In the atomization step, a raw material solution containing the metal is prepared, the raw material solution is atomized, and resulting droplets are suspended in air to generate atomized droplets. A compounding ratio of the metal is not particularly limited, but is preferably 0.0001 mol/L to 20 mol/L based on the whole raw material solution. The atomization method is not particularly limited as long as the raw material solution is atomizable and may be any known method, but is preferably, in the present disclosure, an atomization method using ultrasonic vibration. The mist used in the present disclosure is suspended in air and more preferably e.g. conveyable as a gas suspending in a space with zero initial velocity rather than blowable like a spray. A mist droplet size is not particularly limited and may be about several millimeters, but is preferably 50 µm or smaller, more preferably 1 to 10 µm.

### (Conveyance Step)

In the conveyance step, the atomized droplets are conveyed to the base by the carrier gas. The type of the carrier gas is not particularly limited as long as it does not hinder the object of the present disclosure. Preferable examples of the carrier gas include oxygen, ozone, an inert gas (e.g. nitrogen, argon), and a reducing gas (e.g. hydrogen gas, forming gas). One type or two types or more of carrier gases may be used, and a diluted gas with a carrier gas concentration changed (e.g. 10 time-diluted gas) or the like may be further used as a second carrier gas. The carrier gas may be supplied to not only one location but also two or more locations. A flow rate of the carrier gas is, but not particularly limited to, preferably 5 L/min or lower, more preferably 0.1 to 3 L/min.

### (Film Formation Step)

In the film formation step, the atomized droplets are reacted to form a film on the crystalline substrate. The reaction is not particularly limited as long as the film is formed from the atomized droplets, but in the present disclosure, a thermal reaction is preferable. The thermal reaction only needs to react the atomized droplets by heating, and the reaction condition and the like are not particularly limited either as long as they do not hinder the object of the present disclosure. In this step, the thermal reaction is performed typically at a temperature higher than an evaporation temperature of the solvent for the raw material solution, preferably at a not-too-high temperature or lower, more preferably at 650°C or lower, even more preferably lower than 600°C. The thermal reaction may be carried out under any atmosphere such as vacuum, non-oxygen atmosphere, reducing gas atmosphere, or oxygen atmosphere, and may be carried out under any condition such as atmospheric pressure, pressurization, or reduced-pressure, as long as they do not hinder the object of the present disclosure. However, in the present disclosure, it is preferable to carry out the thermal reaction under atmospheric pressure because of easier calculation of the evaporation temperature, simplification of facilities, and the like. Adjustment of the film formation time makes it possible to set the film thickness.

A film formation device for the above-described mist CVD method will be explained below.

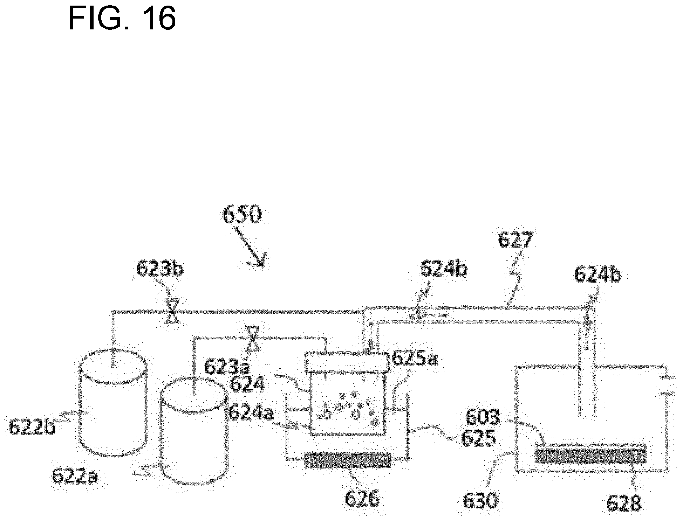

A film formation device 650 in FIG. 16 includes a carrier gas supplier 622a that supplies a carrier gas, a flow rate regulation valve 623a that regulates a flow rate of the carrier gas supplied from the carrier gas supplier 622a, a carrier gas (diluted) supplier 622b that supplies the carrier gas (diluted), a flow rate regulation valve 623b that regulates a flow rate of the carrier gas (diluted) supplied from the carrier gas (diluted) supplier 622b, a mist generator 624 that contains a raw material solution 624a, a container 625 that contains a water 625a, an ultrasonic transducer 626 attached to a bottom of the container 625, a film formation chamber 630, a supply tube 627 that is made of quartz and connects the members from the mist generator 624 to the film formation chamber 630, and a hot plate (heater) 628 disposed in the film formation chamber 630. A substrate 603 is disposed on the hot plate 628.

As illustrated in FIG. 16, the raw material solution 624a is contained in the mist generator 624. Then, the substrate 603 is placed on the hot plate 628, and the hot plate 628 is activated to raise the temperature inside the film formation chamber 630. Subsequently, the flow rate regulation valves 623 (623a and 623b) were opened to supply the carrier gas from the carrier gas sources (carrier gas supplier 622a and carrier gas (diluted) supplier 622b) to the film formation chamber 630, the atmosphere inside the film formation chamber 630 was sufficiently replaced with the carrier gas, then flow rates of the carrier gas and the carrier gas (diluted) were regulated. Subsequently, the ultrasonic transducer 626 was vibrated, and the vibration was propagated to the raw material solution 624a through the water 625a to micronize the raw material solution 624a to produce the atomized droplets 624b. The atomized droplets 624b were introduced into the film formation chamber 630 by the carrier gas, conveyed to the substrate 603, and thermally reacted in the film formation chamber 630 under atmospheric pressure to form a film on the substrate 603.

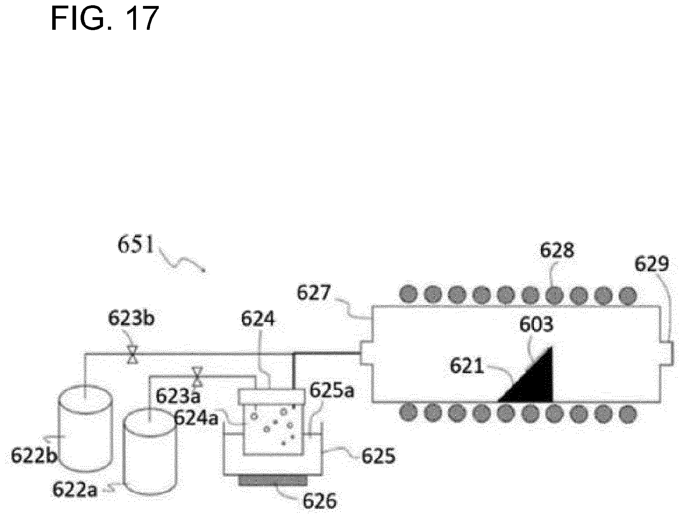

It is also preferable to use a mist CVD device (film forming device) 651 illustrated in FIG. 17. The mist CVD device 651 illustrated in FIG. 17 includes a susceptor 621 on which the substrate 603 is mounted, the carrier gas supplier 622a that supplies the carrier gas, the flow rate regulation valve 623a that regulates the flow rate of the carrier gas supplied from the carrier gas supplier 622a, the carrier gas (diluted) supplier 622b that supplies the carrier gas (diluted), the flow rate regulation valve 623b that regulates the flow rate of the carrier gas supplied from the carrier gas (diluted) supplier 622b, the mist generator 624 that contains the raw material solution 624a, the container 625 that contains the water 625a, the ultrasonic transducer 626 attached to the bottom of the container 625, the supply tube 627 composed of a quartz tube with an inner diameter of 40 mm, the heater 628 disposed on a periphery portion of the supply tube 627, and an exhaust port 629 that discharges mist, droplets, and exhaust gas resulting from the thermal reaction. The susceptor 621 is made of quartz, and its surface on which the substrate 603 is mounted is inclined from a horizontal plane. Both the supply tube 627 as the film formation chamber and the susceptor 621 are made from quartz to prevent the device-derived impurities from contaminating the film formed on the substrate 603. This mist CVD device 651 may be handled in the same way as for the above-described film formation device 650.

The above-described suitable film formation device facilitates formation of the crystalline oxide semiconductor on the crystal growth plane of the crystalline substrate. The crystalline oxide semiconductor is normally formed by an epitaxial crystal growth. The semiconductor device may be made of the crystalline oxide semiconductor by a known means.

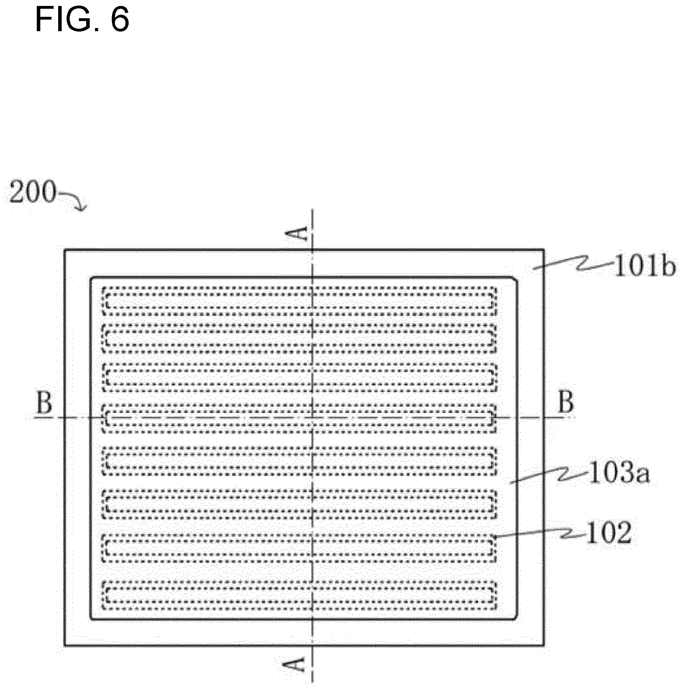

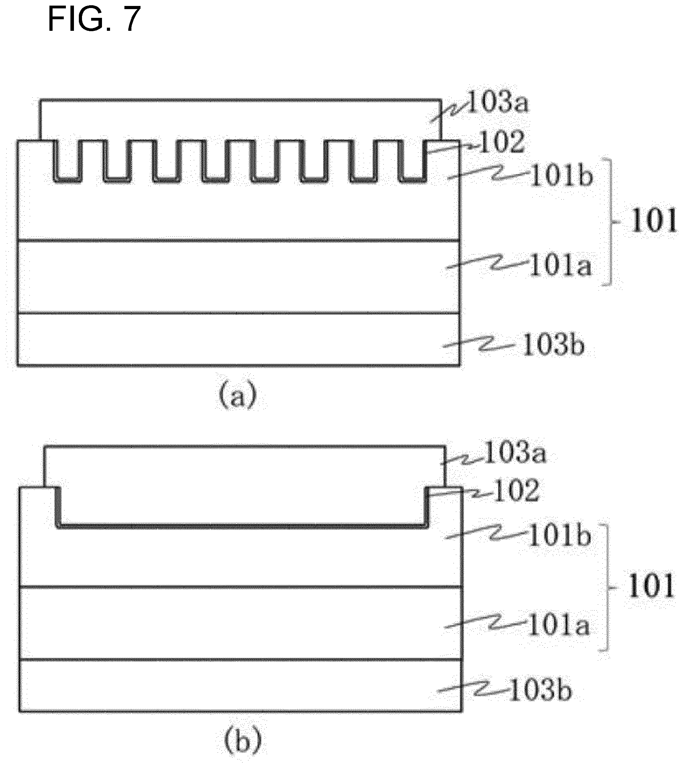

FIG. 6 is a schematic top view of a semiconductor element having a laminated structure according to the first embodiment. FIG. 7(a) and FIG. 7(b) are schematic cross-sectional views of the A and B cross sections respectively in FIG. 6. A semiconductor element 200 in FIG. 6 and FIG. 7 includes an ohmic electrode 103b, the n+ type oxide semiconductor layer 101a, the n- type oxide semiconductor layer 101b, the second oxide layer 102, and a Schottky electrode 103a. The n+ type oxide semiconductor layer 101a and the n- type oxide semiconductor layer 101b constitute the first oxide layer 101. A trench structure is formed on the surface of the n- type oxide semiconductor layer 101b, and the second oxide layer 102 is laminated along the trench grooves of the trench structure. According to the first embodiment, in the second oxide layer 102, a difference in film thickness between centers of the bottom and the sidewall in the trench is less than 30%. Also in the second oxide layer 102, a difference in a second metal content between a region around the center of the bottom and a region around the center of the sidewall in the trench is less than 30%.

The Schottky electrode 103a and the ohmic electrode 103b are not particularly limited as long as they may be used as a Schottky electrode and/or an ohmic electrode respectively. The Schottky electrode 103a and the ohmic electrode 103b may be made of a conductive inorganic material or a conductive organic material. In the present disclosure, it is preferable that the material for the Schottky electrode and/or ohmic electrode is a metal, a metal compound, a metal oxide, or a metal nitride. Preferable examples of the metal include at least one metal selected from Group 4 to Group 11 metals in the periodic table. Examples of the Group 4 metal in the periodic table include titanium (Ti), zirconium (Zr), and hafnium (Hf). Examples of the Group 5 metal in the periodic table include vanadium (V), niobium (Nb), and tantalum (Ta). Examples of the Group 6 metal in the periodic table include one or a plurality of metals selected from chromium (Cr), molybdenum (Mo), and tungsten (W). Examples of the Group 7 metal in the periodic table include manganese (Mn), technetium (Tc), and rhenium (Re). Examples of the Group 8 metal in the periodic table include iron (Fe), ruthenium (Ru), and osmium (Os). Examples of the Group 9 metal in the periodic table include cobalt (Co), rhodium (Rh), and iridium (Ir). Examples of the Group 10 metal in the periodic table include nickel (Ni), palladium (Pd), and platinum (Pt). Examples of the Group 11 metal in the periodic table include copper (Cu), silver (Ag), and gold (Au).

Examples of the methods of forming the Schottky electrode and ohmic electrode include known methods, more specifically a dry method and a wet method. Examples of the dry method include known methods such as sputtering, vacuum deposition, and CVD. Examples of the wet method include screen printing and die coating.

### (Effects of the First Embodiment)

In the laminated structure 100 according to the first embodiment, the second oxide layer 102 inside the trench 104 has an excellent film thickness uniformity. When the second oxide layer 102 is a p type semiconductor layer, it is possible to reduce the difference in thickness of the p type semiconductor layer between the sidewall side and the bottom side. When the oxide in the second oxide layer 102 contains iridium, the layer has an excellent iridium distribution. In this case, the layer also has an excellent acceptor concentration. Since the second oxide layer 102 has an excellent film thickness uniformity, it is considered that a defect density and a crystallinity unevenness of the second oxide layer 102 are suppressed. Such a laminated structure 100 is suitable for semiconductor elements.

### (Example of JBS Diode Preparation)

As an example for confirming an effect of applying the laminated structure according to the first embodiment to a semiconductor element, the second oxide layer is formed by a mist CVD method using a raw material solution containing iridium complexes represented by the above formulas (3) and (4) to prepare a junction barrier Schottky diode (JBS). As a comparative example, the second oxide layer is formed by a mist CVD method using a raw material solution containing an iridium acetylacetonato complex represented by the following formula (5) to prepare a JBS, and electrical properties were compared between the example and the comparative example. In the example and the comparative example, an α-Ga₂O₃ layer was used as the first oxide layer and an α-(Ir, Ga)₂O₃ layer was used as the second oxide layer.

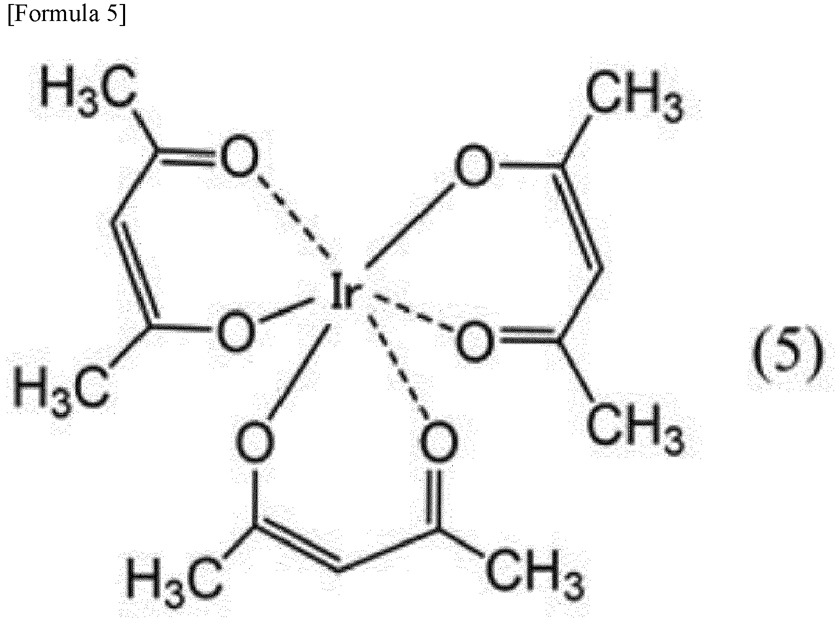

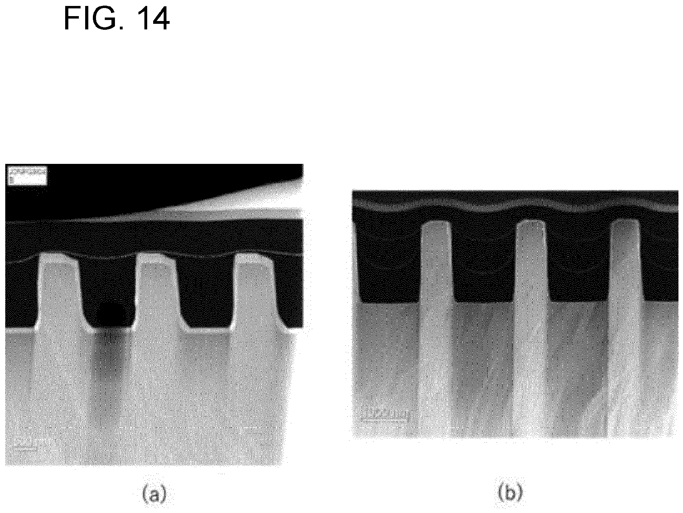

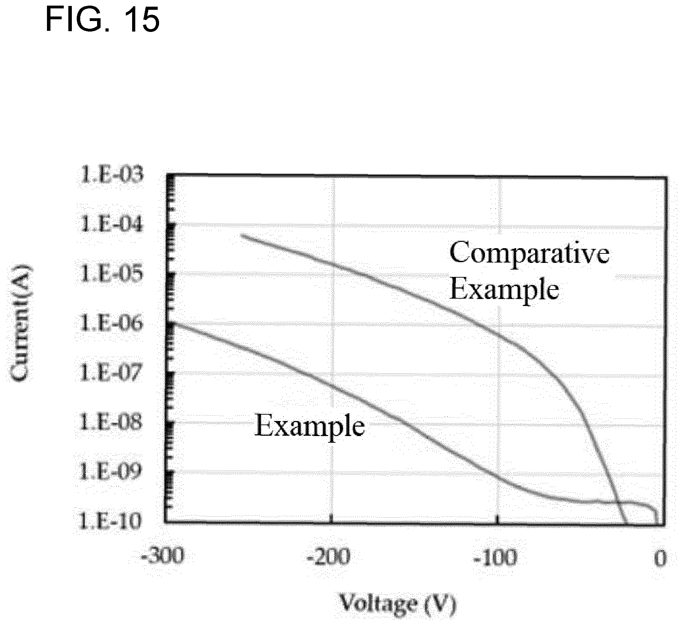

FIG. 14 presents cross-sectional TEM images of the second oxide layer inside the obtained trench structure. Table 1 presents film thicknesses and Ir composition ratios of the bottom center and the sidewall center of the second oxide layer inside the trench in the example and the comparative example. FIG. 15 presents results of current-voltage (I-V) characteristics measured by applying a reverse voltage in the example and the comparative example. As is clear from FIG. 15, it is found that a semiconductor element having a better reverse directional characteristic was obtained in the example.

**[Table 1]**

| | Example | | Comparative Example | |
|---|---|---|---|---|
| Measurement location | Film thickness (nm) | Ir composition ratio (%) | Film thickness (nm) | Ir composition ratio (%) |
| Sidewall center | 87 | 5.2 | 39 | 2.5 |
| Bottom center | 107 | 6.8 | 14 | 24.4 |

### (Second Embodiment)

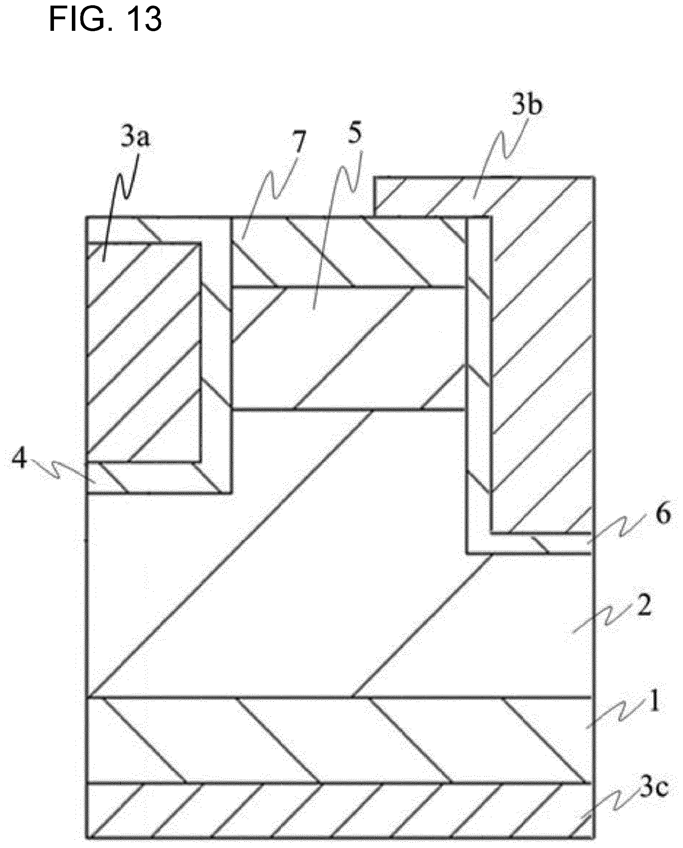

In the second embodiment, another example of the semiconductor element to which the laminated structure according to the present disclosure is applied will be explained. The semiconductor element in FIG. 13 is a metal oxide semiconductor field effect transistor (MOSFET), including an n+ type semiconductor layer 1, an n- type semiconductor layer (first oxide layer) 2, a p- type semiconductor layer (channel layer) 5, a p+ type semiconductor layer (second oxide layer) 6, an n+ type semiconductor layer 7, a gate insulating film 4, a gate electrode 3a, a source electrode 3b, and a drain electrode 3c. The p+ type semiconductor layer (second oxide layer) 6 is at least partially buried in the n- type semiconductor layer 2 down to a position deeper than a buried bottom portion of the gate electrode 3a. As for the semiconductor device in a turned-on state in FIG. 13, a voltage is applied between the source electrode 3b and the drain electrode 3c, and a positive voltage with respect to the source electrode 3b is applied to the gate electrode 3a to form a channel on the interface between the p- type semiconductor layer 5 and the gate insulating film 4, so that the semiconductor device is turned on. As for the turned-off state, the voltage of the gate electrode 3a is lowered to 0 V to extinguish the channel, so that the semiconductor device is turned off. In the semiconductor device in FIG. 13, the p+ type semiconductor layer (second oxide layer) 6 is buried in the n- type semiconductor layer (first oxide layer) 2 down to a position deeper than the gate electrode 3a. This configuration makes it possible to relax the electric field around the lower port of the gate electrode and to improve an electric field distribution in the gate insulating film or the n- type semiconductor layer.

The constituent material for the gate insulating film (interlayer insulating film) is not particularly limited and may be any known material. Examples of the material for the gate insulating film include an SiO₂ film, a phosphorus-containing SiO₂ film (phosphorus-containing SiO₂ glass (PSG) film), a boron-containing SiO₂ film, and a phosphorus-boron-containing SiO₂ film (phosphorus-boron-containing SiO₂ glass (BPSG) film). Examples of the method of forming the gate insulating film include a CVD method, an atmospheric pressure CVD method, a plasma CVD method, and a mist CVD method. In the embodiment of the present disclosure, the method of forming the gate insulating film is preferably a mist CVD method or an atmospheric pressure CVD method. The constituent material for the gate electrode is not particularly limited and may be any known electrode material. Examples of the constituent material for the gate electrode include the above-described constituent materials for the source electrode. The method of forming the gate electrode is not particularly limited. Specific examples of the method of forming the gate electrode include a dry method and a wet method. Examples of the dry method include sputtering, vacuum deposition, and CVD. Examples of the wet method include screen printing and die coating. The materials for the n+ type semiconductor layer 1 and the n- type semiconductor layer 2 may be the same as the material for the semiconductor layer (first oxide layer) described above. The main component of the p+ type semiconductor layer 6 is preferably different from the major component of the p- type semiconductor layer (channel layer) 5.

The materials for the gate electrode, the source electrode, and the drain electrode (hereinafter simply referred to as "electrodes") are not particularly limited as long as they may be used as electrodes, and may be a conductive inorganic material or a conductive organic material. In the present disclosure, it is preferable that the material for the electrode is a metal, a metal compound, a metal oxide, or a metal nitride. Preferable examples of the metal include at least one metal selected from Group 4 to Group 11 metals in the periodic table. Examples of the Group 4 metal in the periodic table include titanium (Ti), zirconium (Zr), and hafnium (Hf). Examples of the Group 5 metal in the periodic table include vanadium (V), niobium (Nb), and tantalum (Ta). Examples of the Group 6 metal in the periodic table include one or a plurality of metals selected from chromium (Cr), molybdenum (Mo), and tungsten (W). Examples of the Group 7 metal in the periodic table include manganese (Mn), technetium (Tc), and rhenium (Re). Examples of the Group 8 metal in the periodic table include iron (Fe), ruthenium (Ru), and osmium (Os). Examples of the Group 9 metal in the periodic table include cobalt (Co), rhodium (Rh), and iridium (Ir). Examples of the Group 10 metal in the periodic table include nickel (Ni), palladium (Pd), and platinum (Pt). Examples of the Group 11 metal in the periodic table include copper (Cu), silver (Ag), and gold (Au).

The method of forming each layer of the semiconductor device in FIG. 13 is not particularly limited as long as it does not hinder the object of the present disclosure, and may be any known means. Examples of the method include a method in which a film is formed by vacuum evaporation, CVD, sputtering, various coating techniques, or the like, and then patterned by photolithography, and a method in which a film is directly patterned by a printing technique. However, in the present disclosure, a mist CVD method is preferable.

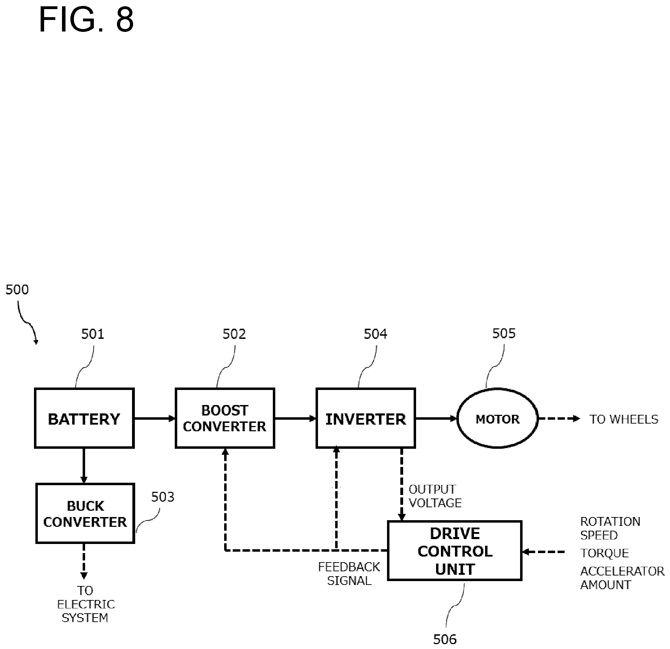

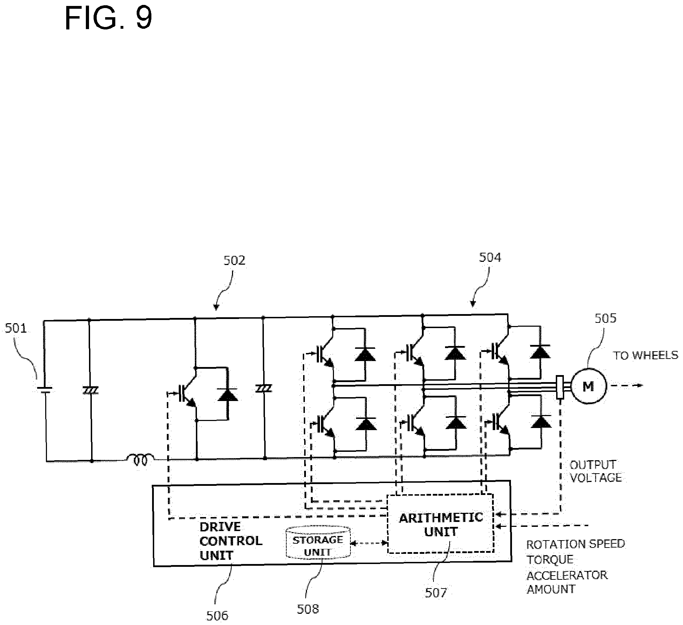

The laminated structure and semiconductor element according to the embodiment of the present disclosure described above may be applied to power conversion devices such as inverters and converters to exhibit the functions described above. FIG. 8 is a block diagram illustrating an example of a control system using the semiconductor element according to the embodiment of the present disclosure, and FIG. 9 is a circuit diagram of the same control system, which is suitably mounted particularly on electric vehicles.

As illustrated in FIG. 8, a control system 500 has a battery (power supply) 501, a voltage step-up converter 502, a voltage step-down converter 503, an inverter 504, a motor (drive object) 505, and a driving controller 506, which are mounted in an electric vehicle. The battery 501 is composed of a storage battery such as a nickel-metal hydride battery and a lithium-ion battery, and is capable of storing electric power by charging at a power supply station or a regenerative energy during deceleration, as well as outputting a direct current voltage required for operation of a traveling system and an electric system of an electric vehicle. The voltage step-up converter 502 is a voltage converter equipped with a chopper circuit, which is capable of rising a direct current voltage of e.g. 200 V supplied from the battery 501 to e.g. 650 V by switching operation of the chopper circuit to output the voltage to the traveling system such as a motor. The voltage step-down converter 503 is also a voltage converter equipped with a chopper circuit, and is capable of reducing a direct current voltage of e.g. 200 V supplied from the battery 501 to e.g. 12 V to output the voltage to the electric system including a power window, a power steering, an on-vehicle electrical equipment, and the like.

The inverter 504 converts the direct current voltage supplied from the voltage step-up converter 502 into a three-phase alternating current voltage by switching operation to output the voltage to the motor 505. The motor 505 is a three-phase alternating current motor that constitutes a traveling system of an electric vehicle, and is rotatively driven by the three-phase alternating current voltage output from the inverter 504 to transmit its rotary drive force to wheels of the electric vehicle via a transmission and the like not illustrated in the figure.

On the other hand, using various sensors not illustrated in the figure, actual values of a revolution speed and a torque of the wheels and an accelerator pedal stepping quantity (accelerator quantity) of an accelerator pedal are measured from the travelling electric vehicle, and these measured signals are input to the driving controller 506. At this time, the output voltage value of the inverter 504 is also input to the driving controller 506. The driving controller 506 has a function of a controller including an arithmetic logical unit such as a central processing unit (CPU) and a data storage unit such as a memory, and generates control signals using the input measured signals and outputs the signals as feedback signals to the inverter 504 to control the switching operation of the switching element. This allows the alternating current voltage supplied to the motor 505 by the inverter 504 to be instantaneously corrected to accurately control the operation of the electric vehicle, so that safe and comfortable operation of the electric vehicle is achieved. It is also possible to control the output voltage supplied to the inverter 504 by transmitting feedback signals from the driving controller 506 to the voltage step-up converter 502.

FIG. 9 is a circuit configuration excluding the voltage step-down converter 503 in FIG. 8, i.e. a circuit configuration illustrating only the configuration for driving the motor 505. As illustrated in FIG. 9, a module unit according to the embodiment of the present disclosure is adopted e.g. as a Schottky barrier diode for the voltage step-up converter 502 and the inverter 504, so as to control the switching. In the voltage step-up converter 502, the module unit is incorporated into the chopper circuit to control the chopper, and in the inverter 504, the module unit is incorporated into a switching circuit including an insulated gate bipolar transistor (IGBT) to control the switching. An inductor (e.g. coil) is provided for the output of the battery 501 to stabilize the current, and capacitors (e.g. electrolytic capacitors) are interposed between each of the battery 501, the voltage step-up converter 502, and the inverter 504 to stabilize the voltage.

As expressed by the dotted line in FIG. 9, an arithmetic logical unit 507 including a CPU, and a memory unit 508 including a nonvolatile memory are disposed inside the driving controller 506. Signals input by the driving controller 506 are transmitted to the arithmetic logical unit 507, where programmed arithmetic operation is executed as necessary to generate feedback signals for each semiconductor element. The memory section 508 temporarily stores the calculation results determined by the arithmetic logical unit 507, accumulates physical constants, functions, or the like necessary for the driving control in a form of a table, and outputs the information to the arithmetic logical unit 507 as appropriate. Any known configuration may be adopted for the arithmetic logical unit 507 and the memory unit 508, and their processing capacities and the like may also be selected as appropriate.

As illustrated in FIG. 8 and FIG. 9, in the control system 500, diodes and switching elements such as thyristors, power transistors, IGBT, and MOSFET are used for switching operations of the voltage step-up converter 502, voltage step-down converter 503, and inverter 504. Gallium oxide (Ga₂O₃), especially a corundum type gallium oxide (α-Ga₂O₃) is used as a material for these semiconductor elements to significantly improve the switching characteristics. Furthermore, application of the module unit according to the embodiment of the present disclosure is expected to achieve extremely good switching characteristics, and to achieve further downsizing and cost reduction of the control system 500. In other words, each of the voltage step-up converter 502, the voltage step-down converter 503, and the inverter 504 are expected to exhibit the effects of the present disclosure, and any one, or any combination of two or more of these members, or any form thereof including the driving controller 506 are all expected to exhibit the effects of to the present disclosure.

The control system 500 described above is applicable to the control systems for all applications such as application of the module unit according to the embodiment of the present disclosure to a control system of an electric vehicle, as well as voltage rising/reduction of electric power from a direct current power supply, and conversion of electric power from a direct current to an alternating current. It is also possible to use power supplies such as solar cells as batteries.

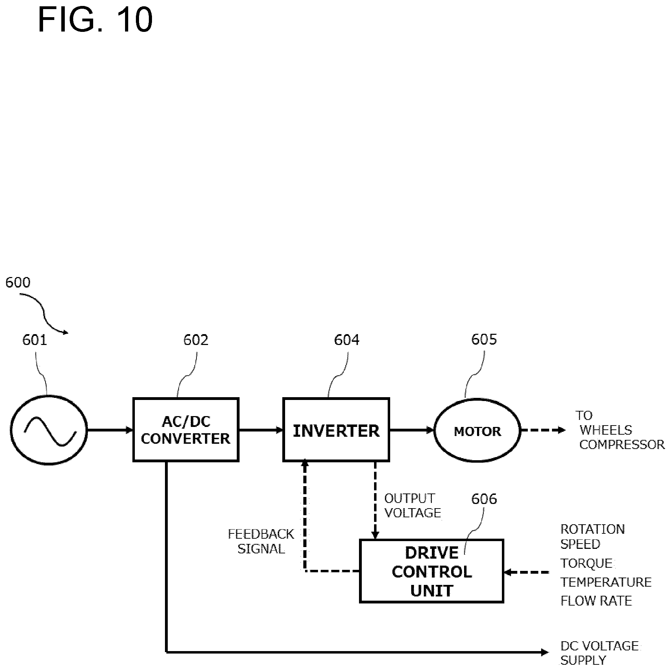

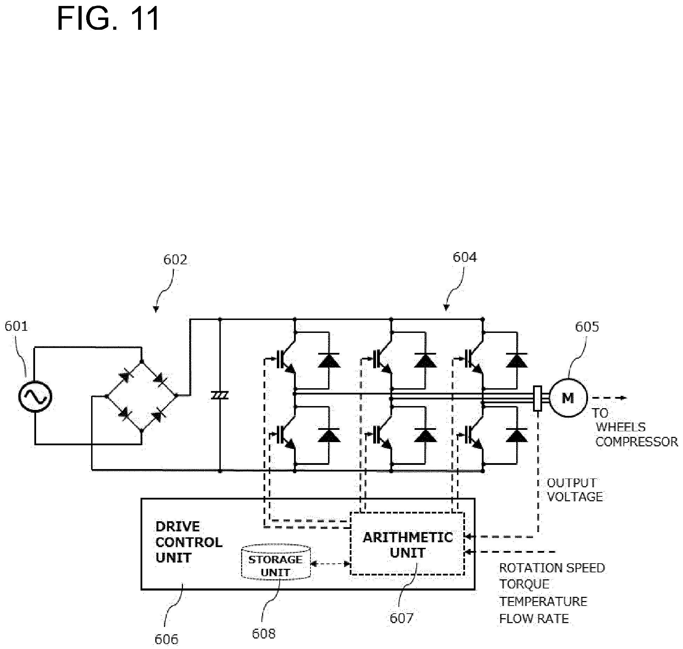

FIG. 10 is a block diagram illustrating another example of the control system using the semiconductor element according to the embodiment of the present disclosure, and FIG. 11 is a circuit diagram illustrating the same control system. The control system is suitably mounted on infrastructure appliances, household electrical appliances, and the like, which operate by an electric power from an alternating current power supply.

As illustrated in FIG. 10, a control system 600 inputs an electric power supplied from an external e.g. three-phase alternating current power supply (power supply) 601, and includes an AC/DC converter 602, an inverter 604, a motor (driving pair) 605, and a driving controller 606, which are mountable on various appliances (described below). The three-phase alternating current power supply 601 is e.g. a power generation facility of an electric power company (e.g. thermal power plant, hydroelectric power plant, geothermal power plant, nuclear power plant), and its output power is supplied as an alternating current voltage while the voltage is stepped down via a substation. Also, the three-phase alternating current power supply 601 is placed, e.g. in a form of a private power generator, in a building or a neighboring facility to supply the output power via power cables. The AC/DC converter 602 is a voltage converter that converts an alternating current voltage into a direct current voltage, and converts an alternating current voltage of 100 V or 200 V supplied from the three-phase alternating current power supply 601 into a predetermined direct current voltage. Specifically, an alternating current voltage is converted into a desired direct current voltage generally used, e.g. 3.3 V, 5 V, or 12 V When a motor is driven, an alternating current voltage is converted into a direct current voltage of 12 V A single-phase alternating current power supply may be adopted instead of the three-phase alternating current power supply. In this case, it is possible to achieve the same system configuration as for the three-phase alternating current power supply by using a single-phase input AC/DC converter.

The inverter 604 converts a direct current voltage supplied from the AC/DC converter 602 into a three-phase alternating current voltage by switching operation and outputs the voltage to the motor 605. The motor 605 is a three-phase alternating current motor that varies in shape depending on an object to be controlled, and is intended to drive wheels in a case of controlling a train, drive a pump and various power sources in a case of controlling a factory equipment, and drive a compressor and the like in a case of controlling a household electrical appliance. The motor 605 is rotatively driven by the three-phase alternating current voltage output from the inverter 604 to transmit its rotary drive force to a drive object not illustrated in the figure.

For example, there are many household electrical appliances to be driven (e.g. personal computers, light-emitting diode (LED) lighting appliances, video appliances, audio appliances) to which a direct current voltage output from the AC/DC converter 602 is able to be directly supplied. In this case, the control system 600 does not require the inverter 604, and, as illustrated in FIG. 10, the direct current voltage is supplied to the drive object from the AC/DC converter 602. In this case, for example, a direct current voltage of 3.3 V is supplied to a personal computer or the like, and a direct current voltage of 5 V is supplied to an LED lighting appliance or the like.

On the other hand, using various sensors not illustrated in the figure, actual values of a revolution speed and a torque of a drive object or an environmental temperature and flow rate of a drive object are measured, and these measured signals are input to the driving controller 606. At this time, the output voltage value of the inverter 604 is also input to the driving controller 606. Based on these measurement signals, the driving controller 606 transmits feedback signals to the inverter 604 to control the switching operation of the switching elements. This allows the alternating current voltage supplied to the motor 605 by the inverter 604 to be instantaneously corrected to accurately control the operation of the drive object, so that stable operation of the drive object is achieved. As described above, when it is possible to drive the drive object by a direct current voltage, it is also possible to feedback-control the AC/DC converter 602 instead of the feedback to the inverter.

FIG. 11 illustrates a circuit diagram in FIG. 10. As illustrated in FIG. 11, the semiconductor device according to the embodiment of the present disclosure is switchingcontrolled e.g. when the semiconductor device is adopted for the AC/DC converter 602 as a Schottky barrier diode, and the inverter 604. As the AC/DC converter 602, e.g. a Schottky barrier diode in a bridged circuit configuration is used, where direct current conversion is performed by converting and rectifying a negative voltage portion of the input voltage into a positive voltage. The inverter 604 is incorporated into a switching circuit in IGBT to control switching. A capacitor (e.g. electrolytic capacitor) is interposed between the AC/DC converter 602 and the inverter 604 to stabilize the voltage.

As expressed by the dotted line in FIG. 11, the driving controller 606 has an arithmetic logical unit 607 including a CPU, and a memory unit 608 including a nonvolatile memory. Signals input into the driving controller 606 are transmitted to the arithmetic logical unit 607, where programmed arithmetic operations are executed as necessary to generate feedback signals for each semiconductor element. The memory unit 608 temporarily stores the results of calculations by the arithmetic logical unit 607 and accumulates physical constants and functions necessary for controlling the driving in a form of tables to output the results to the arithmetic logical unit 607 as appropriate. The arithmetic logical unit 607 and the memory unit 608 may have a known configuration, and their processing capacities and the like may also be arbitrarily selected.

Also in this control system 600, like the control system 500 illustrated in FIG. 8 and FIG. 9, diodes and switching elements such as thyristors, power transistors, IGBT, and MOSFET are used for rectification and switching operations of the AC/DC converter 602 and inverter 604. As materials for these semiconductor elements, gallium oxide (Ga₂O₃), particularly a corundum type gallium oxide (α-Ga₂O₃) is used to improve switching characteristics. Furthermore, application of the module unit according to the embodiment of the present disclosure is expected to achieve extremely good switching characteristics, and to achieve further downsizing and cost reduction of the control system 600. In other words, each of the AC/DC converter 602 and the inverter 604 is expected to exhibit effects of the present disclosure, and any one, or any combination of these members, or any form thereof including the driving controller 606 are all expected to exhibit the effects of the present disclosure.

Although FIG. 10 and FIG. 11 illustrate the motor 605 as a drive object, the drive object is not necessarily limited to mechanically operable objects, but may be targeted to many appliances requiring an alternating current voltage. The control system 600 is applicable as long as a drive object is driven by inputting an electric power from an alternating current power supply. The control system 600 may be installed to control driving of appliances such as infrastructure appliances (e.g. electric power equipment in buildings or factories, communication equipment, traffic control appliances, water and sewage treatment equipment, system appliances, labor-saving appliances, trains) and household electrical appliances (e.g. refrigerators, washing machines, personal computers, LED lighting appliances, video appliances, audio appliances).

The following appendices are attached to the above-described embodiments.

### (Appendix 1)

A laminated structure including a first oxide layer having a trench structure on its surface and a second oxide layer laminated along the trench structure, in which a difference in thickness between centers of a bottom and a sidewall of the second oxide layer is less than 30%.

### (Appendix 2)

A laminated structure including a first oxide layer having a trench structure on its surface and a second oxide layer laminated along the trench structure, in which the second oxide layer contains an oxide of a first metal selected from Group 13 metals in the periodic table and an oxide of a second metal selected from Group 6 metals and Group 9 metals in the periodic table, and a difference in a second metal content between regions around centers of a bottom and a sidewall of the second oxide layer is less than 30%.

### (Appendix 3)

The laminated structure according to appendix 1 or 2, in which the trench structure includes a plurality of trench grooves.

### (Appendix 4)

The laminated structure according to appendix 2 or 3, in which a major component of the second oxide layer is a mixed crystal of the oxide of the first metal and the oxide of the second metal.

### (Appendix 5)

The laminated structure according to any one of appendices 2 to 4, in which the first metal is gallium.

### (Appendix 6)

The laminated structure according to any of appendices 2 to 5, in which the second metal is a Group 9 metal in the periodic table.

### (Appendix 7)

The laminated structure according to appendix 6, in which the second metal is iridium.

### (Appendix 8)

The laminated structure according to any one of appendices 1 to 7, in which the second oxide layer has a minimum film thickness of 30 nm or larger.

### (Appendix 9)

The laminated structure according to any one of appendices 1 to 8, in which the trench structure has a groove depth of within a range of 0.1 µm to 10 µm.

### (Appendix 10)

The laminated structure according to any one of appendices 1 to 9, in which the trench structure has a groove width of within a range of 0.1 µm to 5.0 µm.

### (Appendix 11)

The laminated structure according to any one of appendices 1 to 10, in which the first oxide layer is crystalline.

### (Appendix 12)

The laminated structure according to appendix 11, in which the first oxide layer has a corundum structure.

### (Appendix 13)

The laminated structure according to appendix 12, in which the trench has a bottom of m-plane and a sidewall of c-plane.

### (Appendix 14)

A semiconductor element including the laminated structure according to any one of appendices 1 to 13, and an electrode.

### (Appendix 15)

A power conversion device including the semiconductor element according to appendix 14.

### (Appendix 16)

A control system including the semiconductor element according to appendix 14.

### [Industrial Applicability]

The semiconductor device according to the present disclosure is usable for all fields such as compound semiconductor electronic devices, electronic and electric appliance parts, optical and electrophotographic devices, and industrial components, and is particularly useful for power devices including oxide semiconductor layers.

### [Reference Signs List]

- 1: n+ type semiconductor layer
- 2: n- type semiconductor layer (drift layer)
- 3a: Gate electrode
- 3b: Source electrode
- 3c: Drain electrode
- 4: Gate insulating film
- 5: p- type semiconductor layer (channel layer)
- 6: p+ type semiconductor layer (second oxide layer)
- 7: n+ type semiconductor layer
- 100: Laminated structure
- 101: First oxide layer
- 101a: n+ type oxide semiconductor layer
- 101b: n- type oxide semiconductor layer
- 102: Second oxide layer
- 103a: Schottky electrode
- 103b: Ohmic electrode
- 104: Trench groove
- 500: Control system
- 501: Battery (power supply)
- 502: Voltage step-up converter
- 503: Voltage step-down converter
- 504: Inverter
- 505: Motor (drive object)
- 506: Driving controller
- 507: Arithmetic logical unit
- 508: Memory unit
- 600: Control system
- 601: Three-phase alternating current power supply (power supply)
- 602: AC/DC converter
- 603: Substrate
- 604: Inverter
- 605: Motor (drive object)
- 606: Driving controller
- 607: Arithmetic logical unit
- 608: Memory unit
- 621: Susceptor
- 622a: Carrier gas supplier
- 622b: Carrier gas (diluted) supplier
- 623a: Flow rate regulation valve
- 623b: Flow rate regulation valve
- 624: Mist generator
- 624a: Raw material solution
- 625: Container
- 625a: Water
- 626: Ultrasonic transducer
- 627: Supply tube
- 628: Heater
- 629: Exhaust port
- 630: Film formation chamber
- 650: Film formation device (mist CVD device)
- 651: Film formation device (mist CVD device)

## Claims

1. A laminated structure comprising a first oxide layer having a trench structure on its surface and a second oxide layer laminated along the trench structure, wherein a difference in thickness between centers of a bottom and a sidewall of the second oxide layer is less than 30%.

2. A laminated structure comprising a first oxide layer having a trench structure on its surface and a second oxide layer laminated along the trench structure, wherein the second oxide layer contains an oxide of a first metal selected from Group 13 metals in the periodic table and an oxide of a second metal selected from Group 6 metals and Group 9 metals in the periodic table, and a difference in a second metal content between regions around centers of a bottom and a sidewall of the second oxide layer is less than 30%.

3. The laminated structure according to claim 1 or 2, wherein the trench structure comprises a plurality of trench grooves.

4. The laminated structure according to claim 2 or 3, wherein a major component of the second oxide layer is a mixed crystal of the oxide of the first metal and the oxide of the second metal.

5. The laminated structure according to any one of claims 2 to 4, wherein the first metal is gallium.

6. The laminated structure according to any one of claim 2 to 5, wherein the second metal is a Group 9 metal in the periodic table.

7. The laminated structure according to claim 6, wherein the second metal is iridium.

8. The laminated structure according to any one of claims 1 to 7, wherein the second oxide layer has a minimum film thickness of 30 nm or larger.

9. The laminated structure according to any one of claims 1 to 8, wherein the trench structure has a groove depth of within a range of 0.1 µm to 10 µm.

10. The laminated structure according to any one of claims 1 to 9, wherein the trench structure has a groove width of within a range of 0.1 µm to 5.0 µm.

11. The laminated structure according to any one of claims 1 to 10, wherein the first oxide layer is crystalline.

12. The laminated structure according to claim 11, wherein the first oxide layer has a corundum structure.

13. The laminated structure according to claim 12, wherein the trench structure has a bottom of m-plane and a sidewall of c-plane.

14. A semiconductor element comprising the laminated structure according to any one of claim 1 to 13, and an electrode.

15. A power conversion device comprising the semiconductor element according to claim 14.

16. A control system comprising the semiconductor element according to claim 14.
